# EUROPÄISCHE PATENTSCHRIFT

(11) **EP 3 345 224 B1**
(45) Veröffentlichungstag und Bekanntmachung des Hinweises auf die Patenterteilung: **23.10.2019**
(21) Anmeldenummer: 16757645.3
(22) Anmeldetag: 26.08.2016
(51) Int. Cl.: H01L 33/06, H01S 5/343, H01L 33/30, H01L 33/00

(54) **OPTOELEKTRONISCHER HALBLEITERCHIP UND VERFAHREN ZU DESSEN HERSTELLUNG**
OPTOELECTRONIC SEMICONDUCTOR CHIP AND METHOD FOR PRODUCING SAME
PUCE SEMI-CONDUCTRICE OPTOÉLECTRONIQUE ET PROCÉDÉ DE FABRICATION CORRESPONDANT

(30) Priorität: 31.08.2015 DE 102015114478
(43) Veröffentlichungstag der Anmeldung: 11.07.2018
(73) Patentinhaber: OSRAM Opto Semiconductors GmbH, 93055 Regensburg (DE)
(72) Erfinder: RUDOLPH, Andreas, 93047 Regensburg (DE)
(74) Vertreter: Epping - Hermann - Fischer
(86) Internationale Anmeldenummer: PCT/EP2016/070173
(87) Internationale Veröffentlichungsnummer: WO 2017/036949

(56) Entgegenhaltungen:
- DE-A1-102011 112 713
- US-A- 4 941 025
- US-A- 5 929 462
- US-A1- 2009 194 784

## Beschreibung

Die Erfindung betrifft einen optoelektronischen Halbleiterchip und ein Verfahren zu dessen Herstellung.

Diese Patentanmeldung beansprucht die Priorität der deutschen Patentanmeldung 10 2015 114 786.6.

Die Erzeugung von Strahlung in der aktiven Schicht eines optoelektronischen Halbleiterchips beruht auf der strahlenden Rekombination von Elektronen und Löchern unter Emission eines Photons. Ein möglicher Verlustmechanismus in strahlungsemittierenden Halbleiterchips sind nicht-strahlende Rekombinationen von Elektronen und Löchern. Zur Erhöhung der Effizienz eines optoelektronischen Halbleiterchips ist es daher vorteilhaft, den Anteil von nicht-strahlenden Rekombinationen zu vermindern.

Aus den Druckschriften US 4,941,025 A und US 5,929,462 A sind optoelektronische Halbleiterchips bekannt, bei denen die aktive Schicht als Mehrfach-Quantentopfstruktur ausgebildet ist.

Der Erfindung liegt die Aufgabe zugrunde, einen optoelektronischen Halbleiterchip anzugeben, bei dem nicht-strahlende Rekombinationen von Elektronen und Löchern vermindert sind. Weiterhin soll ein Verfahren zur Herstellung des optoelektronischen Halbleiterchips angegeben werden.

Diese Aufgaben werden durch einen optoelektronischen Halbleiterchip und ein Verfahren gemäß den unabhängigen Patentansprüchen gelöst. Vorteilhafte Ausgestaltungen und Weiterbildungen der Erfindung sind Gegenstand der abhängigen Ansprüche.

Der optoelektronische Halbleiterchip umfasst einen p-Typ-Halbleiterbereich, einen n-Typ-Halbleiterbereich und eine zwischen dem p-Typ-Halbleiterbereich und dem n-Typ-Halbleiterbereich angeordnete aktive Schicht, die als Mehrfach-Quantentopfstruktur ausgebildet ist.

Die Mehrfach-Quantentopfstruktur weist Quantentopfschichten und Barriereschichten auf. Die Barriereschichten weisen eine größere Bandlücke als die Quantentopfschichten auf. Die Mehrfach-Quantentopfstruktur ist insbesondere eine periodische Schichtenfolge, bei der jede Periode eine Quantentopfschicht und eine Barriereschicht aufweist. Bei der hierin beschriebenen Quantentopfstruktur sind die Barriereschichten dotiert, und zwischen den Barriereschichten und den Quantentopfschichten sind undotierte Zwischenschichten angeordnet.

Die Dotierung der Barriereschichten der Mehrfach-Quantentopfstruktur ist vorteilhaft, um bei dem optoelektronischen Halbleiterchip kurze Schaltzeiten zu ermöglichen. Die Barriereschichten sind beispielsweise p-dotiert, wobei der Dotierstoff zum Beispiel Kohlenstoff ist.

Es hat sich herausgestellt, dass sie Dotierung der Barriereschichten vorteilhaft zu Erzielung kurzer Schaltzeiten ist. Andererseits wurde aber herausgefunden, dass an der Grenzfläche zwischen den dotierten Barriereschichten und den Quantentopfschichten vermehrt nicht-strahlende Rekombinationen stattfinden können, falls die Barriereschichten direkt an die Quantentopfschichten angrenzen. Dies beruht insbesondere darauf, dass die Elektronen an der Grenzfläche zwischen den Quantentopfschichten und den Barriereschichten mit den ionisierten Dotierstoffatomen in Berührung kommen können. Genauer ausgedrückt wäre ein Überlapp der Elektronenwellenfunktion mit der Wellenfunktion der Dotierstoffatome bei direkt aneinander angrenzenden Barriereschichten und Quantentopfschichten ungleich null, was nicht-strahlende Rekombinationen und somit einen Helligkeitsverlust zur Folge hätte.

Bei dem hierin beschriebenen optoelektronischen Halbleiterchip wird der Überlapp zwischen der Elektronenwellenfunktion und der Wellenfunktion der ionisierten Dotierstoffatome der Barriereschichten vorteilhaft dadurch reduziert, dass zwischen den dotierten Barriereschichten und den Quantentopfschichten undotierte Zwischenschichten angeordnet sind. Die dotierten Barriereschichten und die Quantentopfschichten grenzen dadurch vorteilhaft nicht unmittelbar aneinander an, sondern sind durch die undotierten Zwischenschichten voneinander beabstandet. Auf diese Weise werden Helligkeitsverluste durch nicht-strahlende Rekombinationen vermindert und so die Effizienz des optoelektronischen Halbleiterchips erhöht.

Gemäß zumindest einer vorteilhaften Ausgestaltung grenzen die dotierten Barriereschichten beidseitig an jeweils eine undotierte Zwischenschicht an. Mit anderen Worten ist in Wachstumsrichtung der Mehrfach-Quantentopfstruktur gesehen sowohl oberhalb als auch unterhalb einer Barriereschicht jeweils eine undotierte Zwischenschicht angeordnet. Die Mehrfach-Quantentopfstruktur kann insbesondere eine periodische Schichtenfolge sein, bei der jede Periode eine erste undotierte Zwischenschicht, eine dotierte Barriereschicht, eine zweite undotierte Zwischenschicht und eine Quantentopfschicht aufweist. Insbesondere kann jede Periode der Mehrfach-Quantentopfschichten aus genau den vier genannten Schichten bestehen. Die Mehrfach-Quantentopfstruktur weist bei dieser Ausgestaltung vorteilhaft keine Grenzflächen zwischen einer dotierten Barriereschicht und einer Quantentopfschicht auf. Verluste durch nicht-strahlende Rekombinationen werden auf diese Weise besonders effektiv vermindert.

Gemäß einer vorteilhaften Ausgestaltung sind die undotierten Zwischenschichten zwischen 1 nm und 10 nm dick. Eine Dicke von mindestens 1 nm ist vorteilhaft, um den Überlapp zwischen der Elektronenwellenfunktion und der Wellenfunktion der Dotierstoffatome in den Barriereschichten effektiv zu vermindern.

Weiterhin ist es vorteilhaft, wenn die undotierten Zwischenschichten vergleichsweise dünn sind, da sich eine zu große Dicke der undotierten Zwischenschichten negativ auf die Schaltzeiten des optoelektronischen Halbleiterchips auswirken könnte. Besonders bevorzugt sind die undotierten Zwischenschichten weniger als 3 nm dick. Weiterhin ist es vorteilhaft, wenn die undotierten Zwischenschichten dünner als die dotierten Barriereschichten sind.

Gemäß einer bevorzugten Ausführungsform basiert die Mehrfach-Quantentopfstruktur auf einem Arsenidverbindungshalbleiter. Vorzugsweise weisen die Quantentopfschichten InₓAl_{y}Ga_{1-x-y}As mit 0 ≤ x ≤ 1, 0 ≤ y ≤ 1 und x + y ≤ 1 auf. Die Barriereschichten und/oder die undotierten Zwischenschichten weisen vorzugsweise AlₘGa₁₋ₘAsₙP₁₋ₙ mit 0 ≤ m ≤ 1 und 0 ≤ n ≤ 1 auf.

Die Bandlücken der Barriereschichten, der Quantentopfschichten und der Zwischenschichten können insbesondere durch die Materialzusammensetzung eingestellt werden. Eine Vergrößerung der Bandlücke kann insbesondere dadurch erzielt werden, dass der Aluminiumgehalt y erhöht und/oder der Indiumgehalt x vermindert wird. Vorzugsweise weisen die Barriereschichten einen größeren Aluminiumgehalt als die Quantentopfschichten auf. Insbesondere können die Quantentopfschichten frei von Aluminium sein. Die Quantentopfschichten weisen vorzugsweise einen größeren Indiumgehalt als die Barriereschichten auf, wobei die Barriereschichten vorzugsweise frei von Indium sind.

Gemäß zumindest einer vorteilhaften Ausgestaltung stimmt die Bandlücke der undotierten Zwischenschichten im Wesentlichen mit der Bandlücke der dotierten Barriereschichten überein. Vorzugsweise beträgt eine Differenz der elektronischen Bandlücken der dotierten Barriereschichten und der undotierten Zwischenschichten nicht mehr als 0,1 eV.

Die undotierten Zwischenschichten weisen daher im Wesentlichen die gleichen elektrooptischen Eigenschaften wie die Barriereschichten auf. Insbesondere weisen die undotierten Zwischenschichten eine größere Bandlücke als die Quantentopfschichten auf und bewirken auf diese Weise wie die Barriereschichten einen Einschluss (Confinement) von Ladungsträgern in den Quantentopfschichten.

Die Barriereschichten weisen abgesehen von einem Dotierstoff im Wesentlichen die gleiche Materialzusammensetzung wie die undotierten Zwischenschichten auf. "Im Wesentlichen die gleiche Materialzusammensetzung" soll hier insbesondere bedeuten, dass der Gehalt der Elemente der Halbleitermaterialien der Barriereschichten und der Zwischenschichten sich jeweils um nicht mehr als 10 %, besonders bevorzugt nicht mehr als 5 % voneinander unterscheidet. Die Barriereschichten weisen Alₘ₁Ga₁₋ₘ₁Asₙ₁P₁₋ₙ₁ mit 0 ≤ m1 ≤ 1 und 0 ≤ n1 ≤ 1 auf. Die undotierten Zwischenschichten weisen Alₘ₂Ga₁₋ₘ₂Asₙ₂P₁₋ₙ₂ mit 0 ≤ m2 ≤ 1 und 0 ≤ n2 ≤ 1 auf. Hierbei gilt |m1- m2| ≤ 0,1, besonders bevorzugt |m1- m2| ≤ 0,05. Weiterhin gilt |n1- n2| ≤ 0,1, besonders bevorzugt |n1- n2| ≤ 0,05.

In den Zwischenschichten gilt vorzugsweise n2 = 1, d.h. die Zwischenschichten weisen vorzugsweise ein ternäres Halbleitermaterial mit der Zusammensetzung Alₘ₂Ga₁₋ₘ₂As mit 0 ≤ m2 ≤ 1 auf. Der Phosphorgehalt der Zwischenschichten 1 - n2 ist somit vorzugsweise gleich null. Ein ternäres Verbindungshalbleitermaterial ist vorteilhaft leichter zu produzieren als ein quaternäres Verbindungshalbleitermaterial. Wenn die Barriereschichten einen Phosphorgehalt 1 - n1 > 0 aufweisen, ist der Aluminiumgehalt m2 in den Barriereschichten vorzugsweise größer als der Aluminiumgehalt m1 der Zwischenschichten. Vorzugsweise gilt also 1- n1 < 0, n2 = 1 und m2 > m1.
Durch den höheren Aluminiumgehalt der Zwischenschichten wird vorteilhaft die Bandlücke angehoben, um einer Verminderung der Bandlücke im Vergleich zu den Barriereschichten durch den fehlenden Phosphorgehalt entgegenzuwirken.

Der optoelektronische Halbleiterchip ist vorzugsweise eine im infraroten Spektralbereich emittierenden Leuchtdiode. Der optoelektronische Halbleiterchip kann beispielsweise eine Emissionswellenlänge zwischen 750 nm und 1000 nm aufweisen.

Das Verfahren zur Herstellung des optoelektronischen Halbleiterchips umfasst gemäß zumindest einer Ausgestaltung ein epitaktisches Aufwachsen einer Halbleiterschichtenfolge, die einen p-Typ-Halbleiterbereich, einen n-Typ-Halbleiterbereich und eine zwischen dem p-Typ-Halbleiterbereich und dem n-Typ-Halbleiterbereich angeordnete aktive Schicht aufweist, die als Mehrfach-Quantentopfstruktur ausgebildet ist. Die Mehrfach-Quantentopfstruktur weist Quantentopfschichten und Barriereschichten auf, wobei die Barriereschichten dotiert sind. Zwischen den Quantentopfschichten und den Barriereschichten wird jeweils eine undotierte Zwischenschicht angeordnet. Das epitaktische Aufwachsen erfolgt vorzugsweise mittels MOVPE.

Bei dem Verfahren werden die undotierten Zwischenschichten vorteilhaft bei einer höheren Wachstumstemperatur aufgewachsen als die dotierten Barriereschichten. Die höhere Wachstumstemperatur beim Aufwachsen der undotierten Zwischenschichten im Vergleich zur Wachstumstemperatur beim Aufwachsen der Barriereschichten hat den Vorteil, dass der ungewollte Einbau von Verunreinigungen in die undotierten Zwischenschichten vermindert wird. Ungewollt eingebaute Verunreinigungen könnten ansonsten als nicht-strahlende Rekombinationszentren fungieren. Durch die Vermeidung von nicht-strahlenden Rekombinationen an Verunreinigungen wird die Effizienz der Strahlungserzeugung in dem optoelektronischen Halbleiterchip vorteilhaft weiter erhöht. Vorzugsweise beträgt die Wachstumstemperatur beim Aufwachsen der undotierten Zwischenschichten mindestens 650 °C.

Die dotierten Barriereschichten werden vorzugsweise bei einer Wachstumstemperatur von weniger als 600 °C aufgewachsen. Die geringere Wachstumstemperatur beim Aufwachsen der Barriereschichten hat den Vorteil, dass der Einbau von Dotierstoffatomen in den Barriereschichten begünstigt wird. Durch eine Reduzierung der Barriereschichten kann ein optoelektronischer Halbleiterchip mit vergleichsweise kurzen Schaltzeiten erzielt werden. Die Barriereschichten können beispielsweise mit C dotiert werden.

Weitere vorteilhafte Ausgestaltungen des Verfahrens ergeben sich aus der Beschreibung des optoelektronischen Bauelements und umgekehrt.

Die Erfindung wird im Folgenden anhand von Ausführungsbeispielen im Zusammenhang mit den Figuren 1 bis 3 näher erläutert.

Es zeigen:
- Figur 1: eine schematische Darstellung eines Querschnitts durch einen optoelektronischen Halbleiterchip gemäß einem Ausführungsbeispiel,
- Figur 2: ein Balkendiagramm der Helligkeit Iₑ der emittierten Strahlung für verschiedene Dicken d_{IL} der Zwischenschichten, und
- Figur 3: ein Balkendiagramm der Anstiegszeiten tᵣᵢₛₑ und der Abfallzeiten t_{fall} der emittierten Strahlung im Pulsbetrieb für verschiedene Dicken d_{IL} der Zwischenschichten.

Die dargestellten Bestandteile sowie die Größenverhältnisse der Bestandteile untereinander sind nicht als maßstabsgerecht anzusehen.

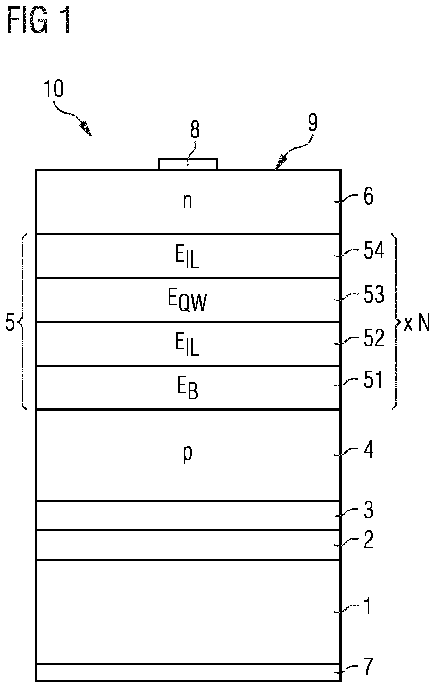

Der in Figur 1 dargestellte optoelektronische Halbleiterchip 10 gemäß einem Ausführungsbeispiel ist ein LED-Chip, der einen p-Typ-Halbleiterbereich 4, einen n-Typ-Halbleiterbereich 6 und eine zwischen dem p-Typ-Halbleiterbereich 4 und dem n-Typ-Halbleiterbereich 6 angeordnete zur Emission von Strahlung geeignete aktive Schicht 5 aufweist. Der LED-Chip 10 ist vorzugsweise ein im infraroten Spektralbereich emittierender LED-Chip.

Bei dem Ausführungsbeispiel des optoelektronischen Halbleiterchips 10 handelt es sich um einen sogenannten Dünnfilm-Halbleiterchip, von dem ein ursprünglich zum epitaktischen Aufwachsen der Halbleiterschichten 4, 5, 6 verwendetes Aufwachssubstrat abgelöst wurde und stattdessen die Halbleiterschichtenfolge mittels einer Verbindungsschicht 2, insbesondere einer Lotschicht, mit einem vom Aufwachssubstrat verschiedenen Trägersubstrat 1 verbunden wurde.

Bei einem solchen Dünnfilm-Leuchtdiodenchip 10 ist der p-Typ-Halbleiterbereich 4 in der Regel dem Trägersubstrat 1 zugewandt. Zwischen dem p-Typ-Halbleiterbereich 4 und dem Trägersubstrat 1 ist vorteilhaft eine Spiegelschicht 3 angeordnet, welche vorteilhaft in Richtung des Trägersubstrats 1 emittierte Strahlung in Richtung zu einer Strahlungsaustrittsfläche 9 des optoelektronischen Halbleiterchips hin umlenkt. Die Spiegelschicht 3 ist beispielsweise eine Metallschicht, die Ag, Al oder Au enthält.

Zur elektrischen Kontaktierung des optoelektronischen Halbleiterchips 10 können beispielsweise eine erste Kontaktschicht 7 an einer Rückseite des Trägersubstrats 1 und eine zweite Kontaktschicht 8 auf einem Teilbereich der Strahlungsaustrittsfläche 9 vorgesehen sein.

Der p-Typ-Halbleiterbereich 4 und der n-Typ-Halbleiterbereich 6 können jeweils aus mehreren Teilschichten aufgebaut sein und müssen nicht notwendigerweise ausschließlich aus p-dotierten Schichten oder n-dotierten Schichten bestehen, sondern können beispielsweise auch eine oder mehrere undotierte Schichten aufweisen.

Alternativ zu dem dargestellten Ausführungsbeispiel könnte der optoelektronische Halbleiterchip 10 auch eine entgegengesetzte Polarität aufweisen, das heißt, es könnte der n-Typ-Halbleiterbereich 6 einem Substrat und der p-Typ-Halbleiterbereich 4 einer Strahlungsaustrittsfläche 9 des optoelektronischen Halbleiterchips zugewandt sein (nicht dargestellt). Dies ist in der Regel bei optoelektronischen Halbleiterchips der Fall, bei denen das zum epitaktischen Aufwachsen der Halbleiterschichten verwendete Aufwachssubstrat nicht abgelöst wird, da in der Regel der n-Typ-Halbleiterbereich zuerst auf das Aufwachssubstrat aufgewachsen wird.

Die zur Emission von Strahlung vorgesehene aktive Schicht des optoelektronischen Halbleiterchips 10 ist als Mehrfach-Quantentopfstruktur 5 ausgebildet. Die Mehrfach-Quantentopfstruktur 5 weist eine Mehrzahl von abwechselnd angeordneten Quantentopfschichten 53 und Barriereschichten 51 auf. Die Quantentopfschichten 53 weisen eine Bandlücke E_{QW} und die Barriereschichten 53 eine Bandlücke E_{B} > E_{QW} auf.
Die Mehrfachquantentopfstruktur 5 ist insbesondere eine periodische Schichtenfolge, die eine Anzahl N Perioden aufweist, wobei N vorzugsweise zwischen 2 und 50 beträgt. Beispielsweise kann die Mehrfachquantentopfstruktur zwölf Perioden aufweisen.

Die Barriereschichten 51 in der Mehrfach-Quantentopfstruktur 5 sind dotiert. Die Dotierstoffkonzentration in den Barriereschichten 51 beträgt vorteilhaft mindestens 1 * 10¹⁸ cm⁻³, vorzugsweise mindestens 1 * 10¹⁹ cm⁻³, beispielsweise etwa 3 * 10¹⁹ cm⁻³. Die Dotierung der Barriereschichten 51 hat den Vorteil, dass bei dem optoelektronischen Halbleiterchip vergleichsweise kurze Schaltzeiten erzielt werden können.

Zwischen den Quantentopfschichten 53 und den Barriereschichten 51 sind vorteilhaft undotierte Zwischenschichten 52, 54 angeordnet. Eine Periode der Quantentopfstruktur kann beispielsweise aus einer dotierten Barriereschicht 51, einer ersten undotierten Zwischenschicht 52, einer Quantentopfschicht 53 und einer zweiten undotierten Zwischenschicht 54 bestehen, wobei die Quantentopfschicht 53 beidseitig jeweils an eine undotierte Zwischenschicht 52, 54 angrenzt. Die Quantentopfschicht 53 weist daher vorteilhaft keine Grenzfläche zu einer dotierten Barriereschicht 51 auf. Dies hat den Vorteil, dass Elektronen in den Quantentopfschichten 53 nicht in unmittelbaren Kontakt mit den ionisierten Dotierstoffatomen der Barriereschichten 51 kommen. Präziser ausgedrückt wird ein Überlapp der Elektronenwellenfunktion mit der Wellenfunktion der ionisierten Dotierstoffatome in den Barriereschichten 51 verringert. Auf diese Weise werden nicht-strahlende Rekombinationen von Elektronen vermindert und auf diese Weise die Effizienz des optoelektronischen Halbleiterchips 10 erhöht.

Die undotierten Zwischenschichten 52, 54 weisen vorzugsweise eine Dicke von mindestens 1 nm und von höchstens 10 nm, besonders bevorzugt von höchstens 3 nm, auf. Die undotierten Zwischenschichten 52, 54 sind vorzugsweise dünner als die Barriereschichten 51 und/oder die Quantentopfschichten 53. Durch die im Vergleich zu den Barriereschichten dünnen undotierten Zwischenschichten werden die durch die Dotierung der Barriereschichten ermöglichten kurzen Schaltzeiten vorzugsweise nicht wesentlich beeinflusst.

Bei dem in Figur 1 dargestellten Ausführungsbeispiel kann zum Beispiel die Barriereschicht 51 eine Dicke von 8,4 nm, die erste undotierte Zwischenschicht 52 eine Dicke von 1,4 nm, die Quantentopfschicht 53 eine Dicke von 4,4 nm und zweite undotierte Zwischenschicht 54 eine Dicke von 1,4 nm aufweisen.

Bei der Herstellung der Mehrfach-Quantentopfstruktur 5 werden die Barriereschichten 51 vorzugsweise bei einer geringeren Wachstumstemperatur aufgewachsen als die undotierten Zwischenschichten 52, 54 und die Quantentopfschichten 53. Das Aufwachsen der Barriereschichten 51 erfolgt bei einer Wachstumstemperatur von vorzugsweise weniger als 600 °C, beispielsweise bei etwa 575 °C. Die undotierten Zwischenschichten 52, 54 und die Quantentopfschichten 53 werden vorzugsweise bei einer Wachstumstemperatur von mehr als 650 °C, beispielsweise bei etwa 665 °C, aufgewachsen.

Durch die höhere Wachstumstemperatur beim Aufwachsen der undotierten Zwischenschichten 52, 54 und der Quantentopfschichten 53 wird der Einbau von Fremdatomen (Verunreinigungen) vorteilhaft gering gehalten. Da Verunreinigungen Zentren für nicht-strahlende Rekombinationen ausbilden können, werden nicht-strahlende Rekombinationen durch eine Verminderung von Verunreinigungen weiter vermindert und so die Effizienz des optoelektronischen Halbleiterchips weiter erhöht.
Die Bandlücken der Halbleitermaterialien der Quantentopfschichten 53, der Barriereschichten 51 und der undotierten Zwischenschichten 52, 54 können insbesondere dadurch eingestellt werden, dass der Aluminiumgehalt und/oder der Indiumgehalt in dem Halbleitermaterial variiert wird. Beispielsweise können die Quantentopfschichten und Barriereschichten Halbleitermaterialien mit der Zusammensetzung InₓAl_{y}Ga_{1-x-y}As oder InₓAl_{y}Ga_{1-x-y}As_{z}P_{1-z} mit 0 ≤ x ≤ 1, 0 ≤ y ≤ 1, x + y ≤ 1 und 0 ≤ z ≤ 1 aufweisen. Bei diesen Typen von Halbleitern nimmt die Bandlücke mit zunehmendem Aluminiumgehalt y zu und mit zunehmendem Indiumgehalt x ab. Bei dem Ausführungsbeispiel der Figur 1 weisen beispielsweise die Quantentopfschichten 53 Ga_{0.92}In_{0.08}As, die Barriereschichten 51 Al_{0.23}Ga_{0.77}As_{0.94}P_{0.06} und die undotierten Zwischenschichten 52, 54 Al_{0.28}Ga_{0.72}As auf.
Die Barriereschichten 51 und die undotierten Zwischenschichten 52, 54 weisen im Wesentlichen die gleiche Materialzusammensetzung auf. Die Barriereschichten 51 weisen Alₘ₁Ga₁₋ₘ₁Asₙ₁P₁₋ₙ₁ mit 0 ≤ m1 ≤ 1 und 0 ≤ n1 ≤ 1 auf. Ein Dotierstoff der Barriereschichten 51 wie zum Beispiel C kann hierbei unberücksichtigt bleiben, da die Konzentration des Dotierstoffs typischerweise um Größenordnungen kleiner ist als die der übrigen Materialkomponenten. Beispielsweise können die Barriereschichten eine Dotierstoffkonzentration von etwa 2 * 10¹⁹ cm⁻³ aufweisen.

Die undotierten Zwischenschichten 52, 54 weisen Alₘ₂Ga₁₋ₘ₂Asₙ₂P₁₋ₙ₂ mit 0 ≤ m2 ≤ 1 und 0 ≤ n2 ≤ 1 auf. Vorzugsweise ist n2 = 1, d.h. die undotierten Zwischenschichten haben keinen Phosphoranteil. Hierbei gilt |m1- m2| ≤ 0,1, besonders bevorzugt |m1- m2| ≤ 0,05. Weiterhin gilt |n1- n2| ≤ 0,1, besonders bevorzugt |n1- n2| ≤ 0,05. Da sich die Materialzusammensetzung der Barriereschichten 51 und der undotierten Zwischenschichten 52, 54 nicht wesentlich voneinander unterscheidet, unterscheidet sich auch die elektronische Bandlücke E_{B} der Barriereschichten nicht Wesentlich von der elektronischen Bandlücke E_{IL} der undotierten Zwischenschichten. Vorzugsweise gilt |E_{B}- E_{IL}| ≤ 0,1 eV, besonders bevorzugt |E_{B}- E_{IL}| ≤ 0,05 eV. Die energetischen Eigenschaften der undotierten Zwischenschichten 52, 54 entsprechen daher im Wesentlichen den Barriereschichten 51.

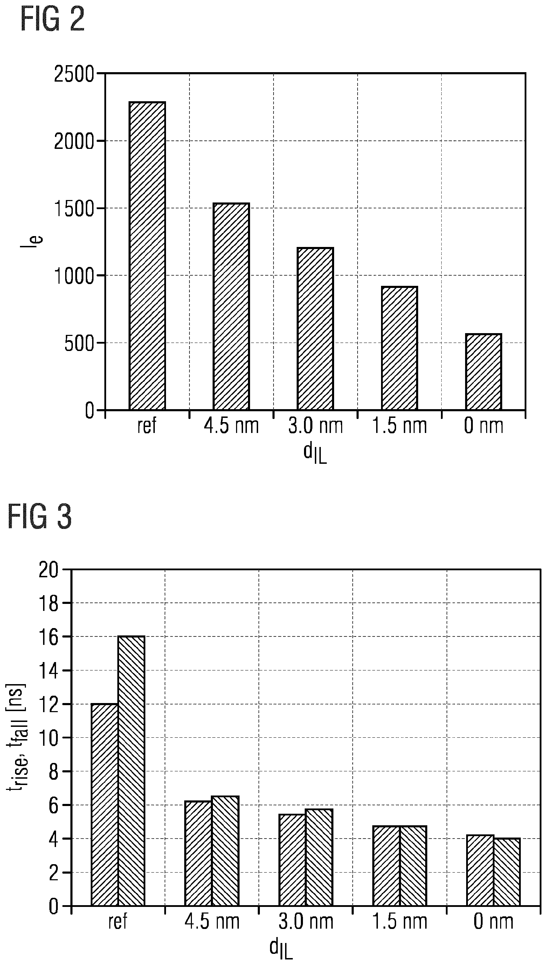

In Figur 2 ist ein Balkendiagramm dargestellt, das die Helligkeit der emittierten Strahlung Iₑ (in willkürlichen Einheiten) für Ausführungsbeispiele von optoelektronischen Halbleiterchips mit verschiedenen Schichtdicken d_{IL} der undotierten Zwischenschichten darstellt. Der mit "0 nm" beschriftete Balken bezieht sich auf ein nicht erfindungsgemäßes Ausführungsbeispiel, bei dem zwischen den Quantentopfschichten und den Barriereschichten keine undotierten Zwischenschichten angeordnet sind. Der mit "ref" beschriftete Balken bezieht sich auf ein weiteres nicht erfindungsgemäßes Ausführungsbeispiel, bei dem die Barriereschichten undotiert sind und zwischen den Quantentopfschichten und den Barriereschichten keine undotierten Zwischenschichten angeordnet sind.

Es zeigt sich, dass für die angeführten Schichtdicken die Helligkeit der emittierten Strahlung mit der Dicke der undotierten Zwischenschichten zunimmt. Dies ist insbesondere auf die Verminderung von nicht-strahlenden Rekombinationen von Ladungsträgern zurückzuführen.

In Figur 3 ist ein weiteres Balkendiagramm dargestellt, dass die Anstiegszeit tᵣᵢₛₑ (linke Balken) und die Abfallzeit t_{fall} (rechte Balken) beim Pulsbetrieb der optoelektronischen Halbleiterchips mit einer Stromstärke von 1 A in Abhängigkeit von der Schichtdicke d_{IL} der undotierten Zwischenschichten darstellt. Es zeigt sich, dass die Schaltzeiten tᵣᵢₛₑ und t_{fall} mit zunehmender Schichtdicke der undotierten Zwischenschichten zunehmen. Die Zunahme der Schaltzeiten ist bei geringen Schichtdicken allerdings nur sehr gering, so dass trotz der undotierten Zwischenschichten noch vergleichsweise kurze Schaltzeiten erzielt werden können. Weiterhin zeigt Fig. 3, dass die Schaltzeiten bei dem mit "ref" gekennzeichneten Vergleichsbeispiel, bei dem die Barriereschichten undotiert sind, wesentlich größer sind. Die Erfindung ist nicht durch die Beschreibung anhand der Ausführungsbeispiele beschränkt, aber wird durch die anhängenden Ansprüche definiert.

### Bezugszeichenliste

- 1: Trägersubstrat
- 2: Verbindungsschicht
- 3: Spiegelschicht
- 4: p-Typ-Halbleiterbereich
- 5: Mehrfach-Quantentopfstruktur
- 6: n-Typ-Halbleiterbereich
- 7: erste Kontaktschicht
- 8: zweite Kontaktschicht
- 9: Strahlungsaustrittsfläche
- 10: optoelektronischer Halbleiterchip
- 51: Barriereschicht
- 52: Zwischenschicht
- 53: Quantentopfschicht
- 54: Zwischenschicht
- 52c: Teilschicht der Barriereschicht
- 53: Zwischenschicht

## Patentansprüche

1. Optoelektronischer Halbleiterchip (10), umfassend:
- einen p-Typ-Halbleiterbereich (4),
- einen n-Typ-Halbleiterbereich (6),
- eine zwischen dem p-Typ-Halbleiterbereich (4) und dem n-Typ-Halbleiterbereich (6) angeordnete aktive Schicht, die als Mehrfach-Quantentopfstruktur (5) ausgebildet ist, wobei
- die Mehrfach-Quantentopfstruktur (5) Quantentopfschichten (53) und Barriereschichten (51) aufweist,
- die Barriereschichten (51) dotiert sind, und
- zwischen den Quantentopfschichten (53) und den Barriereschichten (51) undotierte Zwischenschichten (52, 54) angeordnet sind,
- die Barriereschichten (51) Alₘ₁Ga₁₋ₘ₁Asₙ₁P₁₋ₙ₁ mit 0 ≤ m1 ≤ 1 und 0 ≤ n1 ≤ 1 aufweisen,
- die undotierten Zwischenschichten (52, 54) Alₘ₂Ga₁₋ₘ₂Asₙ₂P₁₋ₙ₂ mit 0 ≤ m2 ≤ 1 und 0 ≤ n2 ≤ 1 aufweisen,
- und wobei |m1- m2| ≤ 0,1 und |n1- n2| ≤ 0,1 ist.

2. Optoelektronischer Halbleiterchip nach Anspruch 1,
wobei die Quantentopfschichten (53) jeweils beidseitig an undotierte Zwischenschichten (52, 54) angrenzen.

3. Optoelektronischer Halbleiterchip nach einem der vorhergehenden Ansprüche,
wobei die undotierten Zwischenschichten (52, 54) zwischen 1 nm und 10 nm dick sind.

4. Optoelektronischer Halbleiterchip nach einem der vorhergehenden Ansprüche,
wobei die undotierten Zwischenschichten (52, 54) weniger als 3 nm dick sind.

5. Optoelektronischer Halbleiterchip nach einem der vorhergehenden Ansprüche,
wobei die undotierten Zwischenschichten (52, 54) dünner als die Barriereschichten (51) sind.

6. Optoelektronischer Halbleiterchip nach einem der vorhergehenden Ansprüche,
wobei die Quantentopfschichten (53) InₓAl_{y}Ga_{1-x-y}As mit 0 ≤ x ≤ 1, 0 ≤ y ≤ 1 und x + y ≤ 1 aufweisen.

7. Optoelektronischer Halbleiterchip nach einem der vorhergehenden Ansprüche,
wobei n2 = 1 ist.

8. Optoelektronischer Halbleiterchip nach einem der vorhergehenden Ansprüche,
wobei sich eine elektronische Bandlücke der undotierten Zwischenschichten (52, 54) um nicht mehr als 0,1 eV von der elektronischen Bandlücke der Barriereschichten (51) unterscheidet.

9. Optoelektronischer Halbleiterchip nach einem der vorhergehenden Ansprüche,
wobei die Barriereschichten (51) abgesehen von einem Dotierstoff die gleiche Materialzusammensetzung wie die undotierten Zwischenschichten (52, 54) aufweisen.

10. Optoelektronischer Halbleiterchip nach einem der vorhergehenden Ansprüche,
wobei der optoelektronische Halbleiterchip (10) eine im infraroten Spektralbereich emittierende Leuchtdiode ist.

11. Verfahren zur Herstellung eines optoelektronischen Halbleiterchips,
umfassend ein epitaktisches Aufwachsen einer Halbleiterschichtenfolge, die einen p-Typ-Halbleiterbereich (4), einen n-Typ-Halbleiterbereich (6) und eine zwischen dem p-Typ-Halbleiterbereich (4) und dem n-Typ-Halbleiterbereich (6) angeordnete aktive Schicht aufweist, die als Mehrfach-Quantentopfstruktur (5) ausgebildet ist, wobei
- die Mehrfach-Quantentopfstruktur (5) Quantentopfschichten (53) und Barriereschichten (51) aufweist,
- die Barriereschichten (51) dotiert sind,
- zwischen den Quantentopfschichten (53) und den Barriereschichten (51) undotierte Zwischenschichte (52, 54) angeordnet sind,
- die undotierten Zwischenschichten (52, 54) bei einer größeren Wachstumstemperatur aufgewachsen werden als die dotierten Barriereschichten (51),
- die Barriereschichten (51) Alₘ₁Ga₁₋ₘ₁Asₙ₁P₁₋ₙ₁ mit 0 ≤ m1 ≤ 1 und 0 ≤ n1 ≤ 1 aufweisen,
- die undotierten Zwischenschichten (52, 54) Alₘ₂Ga₁₋ₘ₂Asₙ₂P₁₋ₙ₂ mit 0 ≤ m2 ≤ 1 und 0 ≤ n2 ≤ 1 aufweisen,
- und wobei |m1- m2| ≤ 0,1 und |n1- n2| ≤ 0,1 ist.

12. Verfahren nach Anspruch 11,
wobei die Wachstumstemperatur beim Aufwachsen der undotierten Zwischenschichten (52, 54) mindestens 650 °C beträgt.

13. Verfahren nach Anspruch 11 oder 12,
wobei die Wachstumstemperatur beim Aufwachsen der Barriereschichten (51) weniger als 600 °C beträgt.

## Claims

1. An optoelectronic semiconductor chip (10), comprising:
- a p-type semiconductor region (4),
- an n-type semiconductor region (6),
- an active layer arranged between the p-type semiconductor region (4) and the n-type semiconductor region (6), said active layer being in the form of a multi-quantum-well structure (5), wherein
- the multi-quantum-well structure (5) comprises quantum-well layers (53) and barrier layers (51),
- the barrier layers (51) are doped, and
- undoped intermediate layers (52, 54) are arranged between the quantum-well layers (53) and the barrier layers (51),
- the barrier layers (51) comprise Alₘ₁Ga₁₋ₘ₁Asₙ₁P₁₋ₙ₁ with 0 ≤ m1 ≤ 1 and 0 ≤ n1 ≤ 1,
- the undoped intermediate layers (52, 54) comprise Alₘ₂Ga₁₋ₘ₂Asₙ₂P₁₋ₙ₂ with 0 ≤ m2 ≤ 1 and 0 ≤ n2 ≤ 1,
- and wherein |m1- m2| ≤ 0.1 and |n1- n2| ≤ 0.1.

2. The optoelectronic semiconductor chip according to claim 1,
wherein the quantum-well layers (53) each adjoin undoped intermediate layers (52, 54) on both sides.

3. The optoelectronic semiconductor chip according to one of the preceding claims,
wherein the undoped intermediate layers (52, 54) are between 1 nm and 10 nm thick.

4. The optoelectronic semiconductor chip according to one of the preceding claims,
wherein the undoped intermediate layers (52, 54) are less than 3 nm thick.

5. The optoelectronic semiconductor chip according to one of the preceding claims,
wherein the undoped intermediate layers (52, 54) are thinner than the barrier layers (51).

6. The optoelectronic semiconductor chip according to one of the preceding claims,
wherein the quantum-well layers (53) comprise InₓAl_{y}Ga_{1-x-y}As with 0 ≤ x ≤ 1, 0 ≤ y ≤ 1 and x + y ≤ 1.

7. The optoelectronic semiconductor chip according to one of the preceding claims,
wherein n2 = 1.

8. The optoelectronic semiconductor chip according to one of the preceding claims,
wherein an electronic band gap of the undoped intermediate layers (52, 54) differs by no more than 0.1 eV from the electronic band gap of the barrier layers (51) .

9. The optoelectronic semiconductor chip according to one of the preceding claims,
wherein the barrier layers (51) have the same material composition as the undoped intermediate layers (52, 54), apart from a dopant.

10. The optoelectronic semiconductor chip according to one of the preceding claims,
wherein the optoelectronic semiconductor chip (10) is a light-emitting diode emitting in the infrared range of the spectrum.

11. A method for producing an optoelectronic semiconductor chip,
comprising an epitaxial growth of a semiconductor layer sequence having a p-type semiconductor region (4), an n-type semiconductor region (6) and an active layer arranged between the p-type semiconductor region (4) and the n-type semiconductor region (6), said active layer being in the form of a multi-quantum-well structure (5), wherein
- the multi-quantum-well structure (5) comprises quantum-well layers (53) and barrier layers (51),
- the barrier layers (51) are doped,
- undoped intermediate layers (52, 54) are arranged between the quantum-well layers (53) and the barrier layers (51),
- the undoped intermediate layers (52, 54) are grown at a higher growth temperature than the doped barrier layers (51)
- the barrier layers (51) comprise Alₘ₁Ga₁₋ₘ₁Asₙ₁P₁₋ₙ₁ with 0 ≤ m1 ≤ 1 and 0 ≤ n1 ≤ 1,
- the undoped intermediate layers (52, 54) comprise Alₘ₂Ga₁₋ₘ₂Asₙ₂P₁₋ₙ₂ with 0 ≤ m2 ≤ 1 and 0 ≤ n2 ≤ 1,
- and wherein |m1- m2| ≤ 0.1 and |n1- n2| ≤ 0.1.

12. The method according to claim 11,
wherein the growth temperature during the growth of the undoped intermediate layers (52, 54) is at least 650°C.

13. The method according to claim 11 or 12,
wherein the growth temperature during the growth of the barrier layers (51) is less than 600°C.

## Revendications

1. Puce semi-conductrice optoélectronique (10), comprenant:
- une région semi-conductrice type p (4),
- une région semi-conductrice type n (6),
- une couche active disposée entre la région semi-conductrice type p (4) et la région semi-conductrice type n (6) configurée comme structure à puits multi-quantique (5),
- la structure à puits multi-quantique (5) présentant des couches à puits quantiques (53) et des couches barrières (51),
- les couches barrières (51) étant dopées, et
- des couches intermédiaires non dopées (52, 54) étant disposées entre les couches à puits quantiques(53) et les couches barrières (51),
- les couches barrières (51) comportant du Alₘ₁Ga₁₋ₘ₁Asₙ₁P₁₋ₙ₁ avec 0 ≤ m1 ≤ 1 et 0 ≤ n1 ≤ 1,
- les couches intermédiaires non dopées (52, 54) comportant du Alₘ₂Ga₁₋ₘ₂Asₙ₂P₁₋ₙ₂ avec 0 ≤ m2 ≤ 1 et 0 ≤ n2 ≤ 1,
- et avec |m1- m2| ≤ 0,1 et |n1- n2| ≤ 0,1.

2. Puce semi-conductrice optoélectronique selon la revendication 1,
dans laquelle les couches à puits quantiques (53) jouxtent chacune des deux côtés des couches intermédiaires non dopées (52, 54).

3. Puce semi-conductrice optoélectronique selon l'une quelconque des revendications précédentes,
dans laquelle les couches intermédiaires non dopées (52, 54) présentent une épaisseur comprise entre 1 nm et 10 nm.

4. Puce semi-conductrice optoélectronique selon l'une quelconque des revendications précédentes,
dans laquelle les couches intermédiaires non dopées (52, 54) présentent une épaisseur inférieure à 3 nm.

5. Puce semi-conductrice optoélectronique selon l'une quelconque des revendications précédentes,
dans laquelle les couches intermédiaires non dopées (52, 54) sont plus minces que les couches barrières (51).

6. Puce semi-conductrice optoélectronique selon l'une quelconque des revendications précédentes,
dans laquelle les couches à puits quantiques (53) comportent du InₓAl_{y}Ga_{1-x-y}As avec 0 ≤ x ≤ 1, 0 ≤ y ≤ 1 et x + y ≤ 1.

7. Puce semi-conductrice optoélectronique selon l'une quelconque des revendications précédentes,
dans laquelle n2 = 1.

8. Puce semi-conductrice optoélectronique selon l'une quelconque des revendications précédentes,
dans laquelle une bande interdite électronique des couches intermédiaires non dopées (52, 54) diffère de 0,1 eV au maximum de la bande interdite électronique des couches barrières (51).

9. Puce semi-conductrice optoélectronique selon l'une quelconque des revendications précédentes,
dans laquelle les couches barrières (51) présentent la même composition de matières que les couches intermédiaires non dopées (52, 54), à l'exception d'un dopant.

10. Puce semi-conductrice optoélectronique selon l'une quelconque des revendications précédentes,
dans laquelle la puce semi-conductrice optoélectronique (10) est une diode électroluminescente émettrice dans le domaine infrarouge.

11. Procède de fabrication d'une puce semi-conductrice optoélectronique,
comprenant une croissance épitaxiale d'une séquence de couches semi-conductrices comprenant une région semi-conductrice type p (4), une région semi-conductrice type n (6) et une couche active disposée entre la région semi-conductrice type p (4) et la région semi-conductrice type n conformée en structure de puits multi-quantique (5), dans lequel
- la structure à puits multi-quantique (5) présente des couches à puits quantiques (53) et des couches barrières (51),
- les couches barrières (51) sont dopées,
- des couches intermédiaires non dopées (52, 54) sont disposées entre les couches à puits quantiques (53) et les couches barrières (51),
- les couches intermédiaires non dopées (52, 54) sont développées à une température de croissance dépassant celle de la croissance des couches barrières dopées (51),
- les couches barrières (51) comportent du Alₘ₁Ga₁₋ₘ₁Asₙ₁P₁₋ₙ₁ avec 0 ≤ m1 ≤ 1 et 0 ≤ n1 ≤ 1,
- les couches intermédiaires non dopées (52, 54) comportent du Alₘ₂Ga₁₋ₘ₂Asₙ₂P₁₋ₙ₂ avec 0 ≤ m2 ≤ 1 et 0 ≤ n2 ≤ 1,
- et avec |m1- m2| ≤ 0,1 et |n1- n2| ≤ 0,1.

12. Procédé selon la revendication 11,
dans lequel la température de croissance est d'au moins 650°C pour la croissance des couches intermédiaires non dopées (52, 54) .

13. Procédé selon la revendication 11 ou la revendication 12,
dans lequel la température de croissance est moins de 600°C pour la croissance des couches barrières (51).
